# FASCICULE DE BREVET EUROPEEN

(11) **EP 3 488 252 B1**
(45) Date de publication et mention de la délivrance du brevet: **20.05.2020**
(21) Numéro de dépôt: 17735590.6
(22) Date de dépôt: 10.07.2017
(51) Int. Cl.: G01R 22/06

(54) **COMPTEUR D'ENERGIE ELECTRIQUE CONFIGURABLE**
KONFIGURIERBARER STROMZÄHLER
CONFIGURABLE ELECTRICITY METER

(30) Priorité: 21.07.2016 FR 1656978
(43) Date de publication de la demande: 29.05.2019
(73) Titulaire: Sagemcom Energy & Telecom SAS, 92500 Rueil-Malmaison (FR)
(72) Inventeur: TEBOULLE, Henri, 92500 Rueil Malmaison (FR); HERGAULT, Stéphane, 92500 Rueil Malmaison (FR)
(74) Mandataire: Lavaud, Thomas
(86) Numéro de dépôt international: PCT/EP2017/067309
(87) Numéro de publication internationale: WO 2018/015202

(56) Documents cités:
- US-A- 5 001 420
- US-A- 5 059 896
- US-A1- 2007 007 944
- US-B1- 6 611 772

## Description

L'invention concerne le domaine des compteurs d'énergie électrique.

### ARRIERE PLAN DE L'INVENTION

On distingue classiquement deux types de compteurs d'énergie électrique destinés à mesurer la consommation d'énergie électrique fournie par un réseau de distribution à une installation électrique.

Des premiers compteurs sont destinés à être connectés directement à un ou plusieurs conducteurs de phase d'un réseau de distribution, sur lesquels circulent typiquement des courants de quelques dizaines d'ampères sous des tensions de quelques centaines de volts.

Des deuxièmes compteurs sont destinés à être connectés à un ou plusieurs conducteurs de phase d'un réseau de distribution, sur lesquels circulent typiquement des courants de plusieurs centaines d'ampères, via un ou des transformateurs situés sur les conducteurs de phase. Ces transformateurs présentent typiquement un rapport de transformation compris entre 100 et 1000.

La connexion au réseau de distribution via les transformateurs oblige à concevoir des deuxièmes compteurs différents des premiers compteurs. Les deuxièmes compteurs possèdent notamment des interfaces mécaniques et des ports de connexion aux conducteurs de phase différents de ceux des premiers compteurs. Il est donc nécessaire de concevoir, de qualifier et de fabriquer deux types de compteurs différents, ce qui augmente le coût de chaque type de compteur.

Le document US 2007/007944 A1 décrit un compteur d'énergie électrique configurable selon une première configuration dans laquelle le compteur est adapté à être connecté directement à un conducteur de phase d'un réseau de distribution, et selon une deuxième configuration dans laquelle le compteur est adapté à être connecté au conducteur de phase via un transformateur situé sur le conducteur de phase, le compteur comportant un port de courant amont et un port de courant aval destinés à être connectés au conducteur de phase et un port de tension.

### OBJET DE L'INVENTION

L'invention a pour objet de réduire le coût d'un compteur électrique.

### RESUME DE L'INVENTION

En vue de la réalisation de ce but, on propose un compteur d'énergie électrique configurable selon une première configuration dans laquelle le compteur est adapté à être connecté directement à un conducteur de phase d'un réseau de distribution, et selon une deuxième configuration dans laquelle le compteur est adapté à être connecté au conducteur de phase via un transformateur situé sur le conducteur de phase, le compteur comportant un port de courant amont et un port de courant aval destinés à être connectés au conducteur de phase, un port de tension, un coupe-circuit fermé par défaut comprenant un contact mobile ayant une extrémité fixe connectée au port de tension et une extrémité mobile connectée au port de courant amont lorsque le coupe-circuit est fermé, un dispositif d'accueil adapté à accueillir un module d'adaptation, et un orifice d'accès au travers duquel s'étend un élément conducteur du module d'adaptation lorsque celui-ci est monté sur le compteur, de sorte que, lorsque le module d'adaptation est monté sur le compteur, l'élément conducteur est en contact avec le contact mobile du coupe-circuit et ouvre le coupe-circuit tout en étant connecté avec le port de tension, le compteur se trouvant alors dans la deuxième configuration, et lorsque le module d'adaptation n'est pas monté sur le compteur, le compteur se trouve dans la première configuration.

Le compteur selon l'invention est donc adapté à fonctionner soit en étant directement connecté au conducteur de phase du réseau de distribution, soit en étant connecté au conducteur de phase via un transformateur situé sur le conducteur de phase. Ces deux modes de connexion au réseau de distribution ne nécessitent donc qu'un seul type de compteur, ce qui réduit nettement les coûts de développement, de test et de fabrication du compteur. La configuration du compteur est simple et peu coûteuse à effectuer, puisqu'elle consiste uniquement à monter le module d'adaptation sur le compteur.

L'invention concerne aussi un module d'adaptation adapté à configurer un compteur tel que celui qui vient d'être décrit.

L'invention concerne aussi un système comprenant un compteur et un module d'adaptation.

L'invention concerne aussi un procédé de configuration d'un tel compteur.

L'invention sera mieux comprise à la lumière de la description qui suit d'un mode de mise en œuvre particulier non limitatif de l'invention.

### BREVE DESCRIPTION DES DESSINS

Il sera fait référence aux dessins annexés, parmi lesquels :

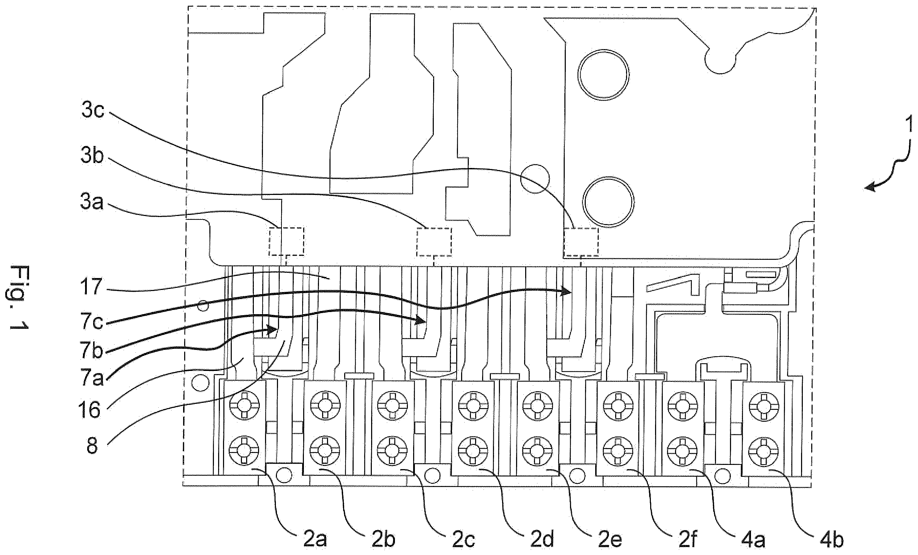

- la figure 1 est une vue de l'intérieur d'un compteur selon l'invention ;

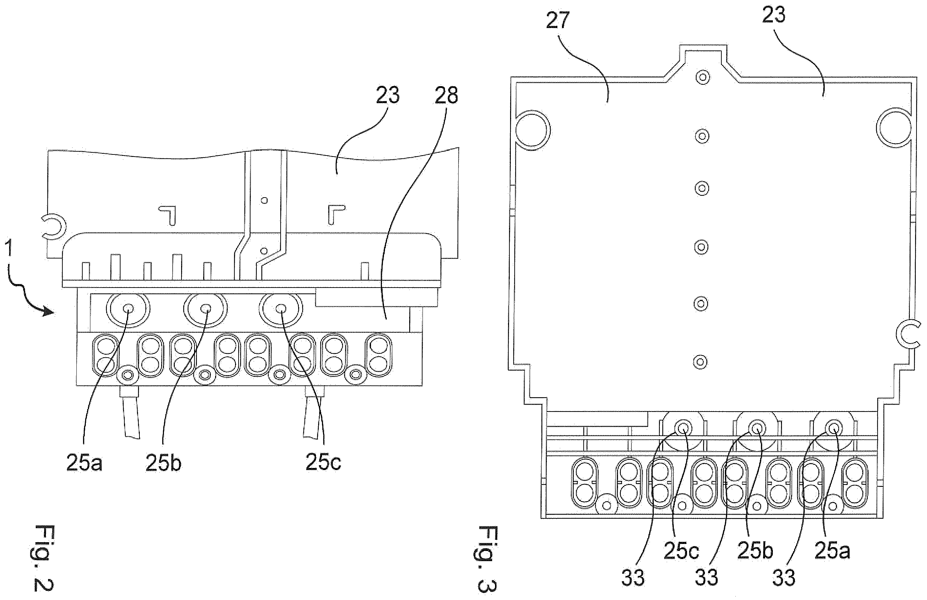

- la figure 2 est une vue de dessus du compteur selon l'invention, le module d'adaptation n'étant pas monté sur le compteur ;
- la figure 3 est une vue de dessous d'une base fixe du compteur selon l'invention ;

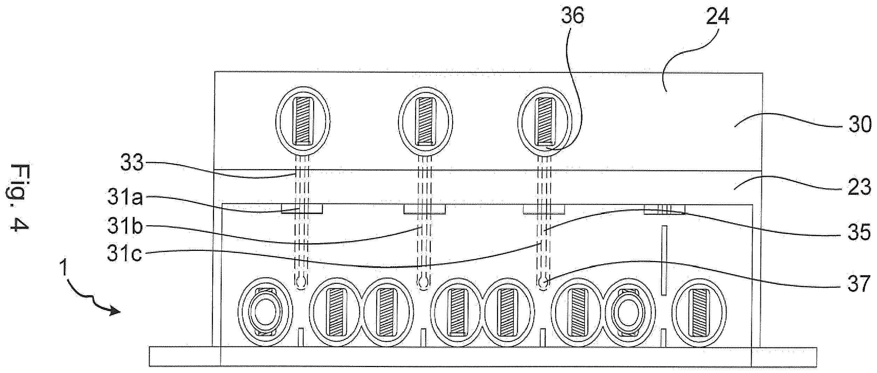

- la figure 4 représente le module d'adaptation monté sur le compteur selon l'invention, le module d'adaptation étant vu de face ;

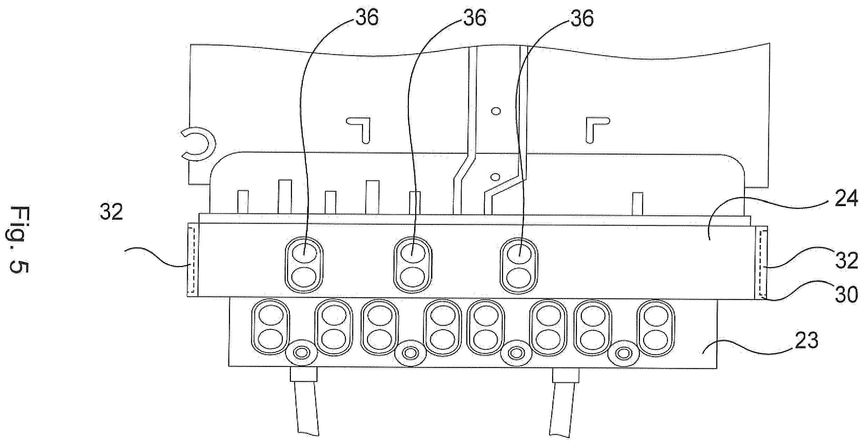

- la figure 5 est une vue analogue à la figure 4, le module d'adaptation étant vu de dessus ;
- la figure 6 est un schéma électrique équivalent au compteur selon l'invention connecté directement à des conducteurs de phase d'un réseau de distribution ;
- la figure 7 est un schéma électrique équivalent au compteur selon l'invention connecté via des transformateurs aux conducteurs de phase d'un réseau de distribution.

### DESCRIPTION DETAILLEE DE L'INVENTION

En référence aux figures, l'invention concerne un compteur d'énergie 1, qui est ici un compteur triphasé.

Le compteur 1 comporte un premier port de courant amont 2a, un premier port de courant aval 2b, un premier port de tension 3a, un deuxième port de courant amont 2c, un deuxième port de courant aval 2d, un deuxième port de tension 3b, un troisième port de courant amont 2e, un troisième port de courant aval 2f, un troisième port de tension 3c, un premier port de neutre 4a, et un deuxième port de neutre 4b.

Alors que les ports de courant 2 et les ports de neutre 4 sont accessibles directement depuis l'extérieur du compteur 1 pour être connectés à un réseau de distribution 6, les ports de tension 3 sont des ports internes au compteur 1 et ne sont pas accessibles depuis l'extérieur du compteur 1.

Le compteur 1 comporte de plus un premier coupe-circuit 7a, un deuxième coupe-circuit 7b et un troisième coupe-circuit 7c. Le premier coupe-circuit 7a est connecté entre le premier port de courant amont 2a et le premier port de tension 3a. Le deuxième coupe-circuit 7b est connecté entre le deuxième port de courant amont 2c et le deuxième port de tension 3b. Le troisième coupe-circuit 7c est connecté entre le troisième port de courant amont 2e et le troisième port de tension 3c.

Chaque coupe-circuit 7 est normalement fermé. Chaque coupe-circuit 7 comporte un contact mobile 8 en cuivre ayant une extrémité fixe connectée au port de tension 3 associé et une extrémité mobile connectée au port de courant amont 2a, 2c, 2e associé lorsque le coupe-circuit 7 est fermé.

Le compteur 1 comporte de plus des moyens de traitement et des moyens de mesure. Les moyens de traitement comprennent un module de traitement, ici un microcontrôleur 9. Les moyens de mesure comprennent un convertisseur analogique numérique 10 relié au microcontrôleur 9, un premier capteur de courant 12a relié au premier port de courant amont 2a et au premier port de courant aval 2b, un premier capteur de tension 13a relié au premier port de tension 3a (et donc au contact mobile 8 du premier coupe-circuit 7a), un deuxième capteur de courant 12b relié au deuxième port de courant amont 2c et au deuxième port de courant aval 2d, un deuxième capteur de tension 13b relié au deuxième port de tension 3b (et donc au contact mobile 8 du deuxième coupe-circuit 7b), un troisième capteur de courant 12c relié au troisième port de courant amont 2e et au troisième port de courant aval 2f, un troisième capteur de tension 13c relié au troisième port de tension 3c (et donc au contact mobile 8 du troisième coupe-circuit 7c).

Chaque capteur de courant 12 est relié à un port de courant amont 2a, 2c, 2e par un premier bras de cuivre 16 et à un port de courant aval 2b, 2d, 2f par un deuxième bras de cuivre 17. Chaque capteur de courant 12 comporte un transformateur interne 18 en forme de tore monté respectivement entre le port de courant amont 2a, 2c, 2e et le port de courant aval 2b, 2d, 2f, et une résistance 19 montée en parallèle du transformateur interne 18. Le transformateur interne 18 assure une isolation galvanique. Le transformateur interne 18 présente ici un rapport de transformation égal à 2500. La résistance 19 possède une borne reliée à une entrée du convertisseur analogique numérique 10 et une borne reliée au premier port de neutre 4a du compteur 1 (et à une masse du compteur 1) . La résistance 19 transforme le courant circulant dans le transformateur interne 18 en une tension. Le convertisseur analogique numérique 10 mesure une tension image du courant circulant respectivement entre le port de courant amont 2a, 2c, 2e et le port de courant aval 2b, 2d, 2f.

Chaque capteur de tension 13 comporte une première résistance 20 et une deuxième résistance 21. La première résistance 20 possède une borne reliée au port de tension 3 associé et une borne reliée à une borne de la deuxième résistance 21. L'autre borne de la deuxième résistance 21 est reliée au premier port de neutre 4a. Les bornes de la première résistance 20 et de la deuxième résistance 21 qui sont reliées entre elles sont aussi reliées à une entrée du convertisseur analogique numérique 10. La première résistance 20 et la deuxième résistance 21 jouent le rôle d'un diviseur de tension qui ramène la tension au niveau du port de tension 3 à un niveau acceptable pour le convertisseur analogique numérique 10. Le convertisseur analogique numérique 10 mesure une tension image de la tension du port de tension 3.

Le microcontrôleur 9 acquiert les mesures de courant et les mesures de tension numériques produites par le convertisseur analogique numérique 10, et exécute un traitement sur les mesures de courant et les mesures de tension numériques pour obtenir des mesures correspondant aux courants et aux tensions effectivement présents sur le réseau de distribution 6.

Le compteur 1 comporte de plus une base fixe 23 en plastique, un dispositif d'accueil adapté à accueillir un module d'adaptation 24, et un détecteur adapté à détecter si le module d'adaptation 24 est monté ou non sur le compteur 1.

Le compteur 1 comporte un capot amovible (non représenté) qui permet de protéger l'accès aux connecteurs. Le capot amovible, lorsqu'il est monté sur le compteur 1, est positionné sur une face avant du compteur 1 (c'est-à-dire sur une face opposée à une face du compteur 1 destinée à être fixée à un mur) . Le capot amovible permet d'accéder à l'intérieur du compteur 1, notamment au cours de la fabrication et des phases de test du compteur 1. Il est bien sûr possible de fermer le capot amovible de manière irréversible (le capot amovible peut être scellé au compteur 1 lorsque celui-ci est installé).

La base fixe 23 comporte un premier orifice d'accès 25a, un deuxième orifice d'accès 25b et un troisième orifice d'accès 25c. Les orifices d'accès 25 relient l'extérieur du compteur 1 à l'intérieur du compteur 1.

Chaque orifice d'accès 25 comporte un guide en plastique 33 qui s'étend perpendiculairement à une face interne 27 de la base fixe 23. Les orifices d'accès 25 sont positionnés de sorte que le premier orifice d'accès 25a débouche dans le compteur 1 en face du contact mobile 8 du premier coupe-circuit 7a, le deuxième orifice d'accès 25 débouche dans le compteur 1 en face du contact mobile 8 du deuxième coupe-circuit 7b, et le troisième orifice d'accès 25c débouche dans le compteur 1 en face du contact mobile 8 du troisième coupe-circuit 7c.

Le dispositif d'accueil du module d'adaptation comporte une cavité 28 pratiquée sur la base fixe 23, les orifices d'accès 25 eux-mêmes, ainsi que des moyens d'encliquetage formés sur la base fixe 23.

Le module d'adaptation 24, quant à lui, comporte un boîtier 30, un premier élément conducteur 31a, un deuxième élément conducteur 31b et un troisième élément conducteur 31c. Chaque élément conducteur 31, de forme longitudinale, est entouré par un guide cylindrique 33 en plastique.

Le boîtier 30 est de forme extérieure générale parallélépipédique. Le fond du boîtier 30 présente une forme complémentaire de la cavité 28 du dispositif d'accueil, de sorte que le boîtier 30 du module d'adaptation peut venir s'emboîter dans la base fixe 23. Le boîtier 30 comporte de plus un dispositif de fixation, comprenant en l'occurrence des moyens d'encliquetage 32, formés sur des faces latérales du boîtier 30. Lorsque le module d'adaptation 24 est monté sur le compteur 1 et que le boîtier 30 est emboîté dans la base fixe 23, les moyens d'encliquetage 32 du boîtier 30 coopèrent avec les moyens d'encliquetage de la base fixe 23 pour fixer le boîtier et donc le module d'adaptation 24 à la base fixe 23 du compteur 1.

Chaque élément conducteur 31 comporte une tige conductrice 35 qui comprend à une première extrémité un organe de connexion 36 et qui présente une deuxième extrémité élargie 37.

Les éléments conducteurs 31 (et les guides cylindriques 33) s'étendent depuis le boîtier 30 et viennent saillir du boîtier 30 de sorte que, lorsque le boîtier 30 est emboîté dans la base fixe 23, chaque élément conducteur 31 (et son guide cylindrique 33) s'étend dans un orifice d'accès 25. Lorsque les éléments conducteurs 31 sont introduits dans les orifices d'accès 25, la deuxième extrémité élargie 37 de la tige conductrice 35 de chaque élément conducteur 31 vient en contact avec le contact mobile 8 d'un coupe-circuit 7, et ouvre le coupe-circuit 7 tout en demeurant en contact avec le contact mobile 8. La tige conductrice 35 et donc l'organe de connexion 36 sont ainsi connectés avec le port de tension 3 associé. Lorsque l'élément conducteur 31 est introduit entièrement, la deuxième extrémité élargie 37 forme un organe d'encliquetage qui coopère avec un organe d'encliquetage complémentaire du compteur 1 pour encliqueter dans le compteur 1 l'élément conducteur 31.

Le détecteur du compteur 1, adapté à détecter si le module d'adaptation 24 est monté ou non sur le compteur 1, comporte un bouton poussoir relié au microcontrôleur 9. Lorsque le module d'adaptation 24 est monté sur le compteur 1, un picot en plastique formé sur le module d'adaptation 24 vient appuyer sur le bouton poussoir. Le microcontrôleur 9 détecte ainsi que le module d'adaptation 24 est monté sur le compteur 1.

Le compteur 1 est un compteur configurable selon une première configuration, dans laquelle le compteur 1 est adapté à être connecté directement aux conducteurs de phase 40 du réseau de distribution 6, et selon une deuxième configuration, dans laquelle le compteur 1 est adapté à être connecté aux conducteurs de phase 40 du réseau de distribution 6 via des transformateurs 41 situés sur les conducteurs de phase 40.

Dans la première configuration, le module d'adaptation 24 n'est pas monté sur le compteur 1. Dans la deuxième configuration, le module d'adaptation 24 est monté sur le compteur 1.

La configuration du compteur 1 consiste donc tout d'abord à déterminer si le compteur 1 est destiné à être connecté directement aux conducteurs de phase 40 du réseau de distribution 6, ou bien si le compteur 1 est destiné à être connecté aux conducteurs de phase 40 via les transformateurs 41 situés sur les conducteurs de phase 40. Puis, si le compteur 1 est destiné à être connecté aux conducteurs de phase 40 via les transformateurs 41, la configuration du compteur 1 consiste à monter le module d'adaptation 24 sur le compteur 1.

La configuration du compteur 1 peut être réalisée en usine, à l'issue de la fabrication du compteur 1 et préalablement à la livraison du compteur 1 au distributeur d'énergie électrique. La configuration du compteur 1 peut aussi être réalisée par le distributeur d'énergie électrique lui-même, qui gère ainsi un seul stock de compteurs 1 semblables. Le distributeur d'énergie électrique configure alors les compteurs 1, préalablement à leur installation, en fonction de la configuration requise.

On décrit maintenant plus en détail la manière dont est connecté le compteur 1 au réseau de distribution 6, selon que le compteur 1 est connecté directement au réseau de distribution 6 ou bien via les transformateurs 41.

Lorsque le compteur 1 est destiné à être connecté directement au réseau de distribution 6 qui alimente en énergie électrique une installation électrique 42 d'un client, le module d'adaptation 24 n'est pas monté sur le compteur 1, et le compteur 1 se trouve dans la première configuration.

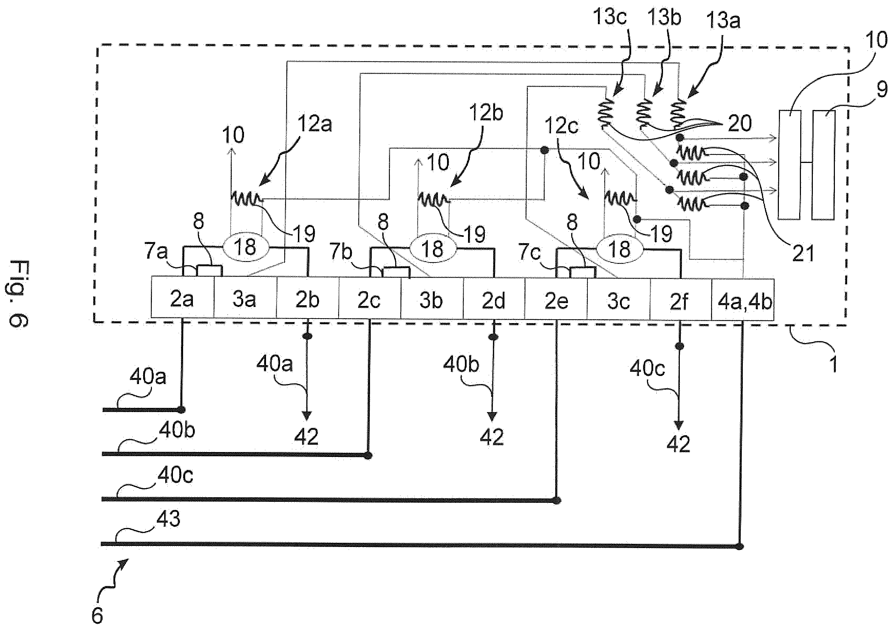

Cette situation est visible sur la figure 6. Les conducteurs de phase 40 du réseau de distribution 6 ne comportent pas de transformateur.

Le premier port de courant amont 2a du compteur 1 est connecté à un premier conducteur de phase 40a du réseau de distribution 6 en amont du compteur 1, alors que le premier port de courant aval 2b est connecté au premier conducteur de phase 40a en aval du compteur 1. Le premier coupe-circuit 7a est fermé. Le premier capteur de courant 12a mesure le courant qui circule entre le premier port amont 2a et le premier port aval 2b, et donc le courant qui circule sur le premier conducteur de phase 40a. Le premier capteur de tension 13a, connecté au premier port de tension 3a et donc au premier port de courant amont 2a via le contact mobile 8 du premier coupe-circuit 7a (qui est fermé). Le premier capteur de tension 13a mesure donc la tension sur le premier conducteur de phase 40a en amont du compteur 1.

Tout ceci s'applique aussi au deuxième conducteur de phase 40b (avec le deuxième capteur de courant 12b et le deuxième capteur de tension 13b) et au troisième conducteur de phase 40c (avec le troisième capteur de courant 12c et le troisième capteur de tension 13c).

Le premier port de neutre 4a (qui est équipotentiel au deuxième port de neutre 4b, la barre de cuivre interne étant la même pour le premier port de neutre 4a et pour le deuxième port de neutre 4b) du compteur 1 est connecté au conducteur de neutre 43 du réseau de distribution 6. Le deuxième port de neutre 4b est connecté à une masse de l'installation électrique 42 du client.

Comme le module d'adaptation 24 n'est pas monté sur le compteur 1, le détecteur ne détecte pas la présence du module d'adaptation 24. Le microcontrôleur 9 effectue donc un premier traitement utilisant des premiers paramètres sur les mesures de courant et de tension. En particulier, le premier traitement prend en compte le fait que le compteur 1 est connecté directement au réseau de distribution 6, et non via des transformateurs, pour obtenir des mesures correspondant aux courants et aux tensions effectivement présents sur le réseau de distribution 6.

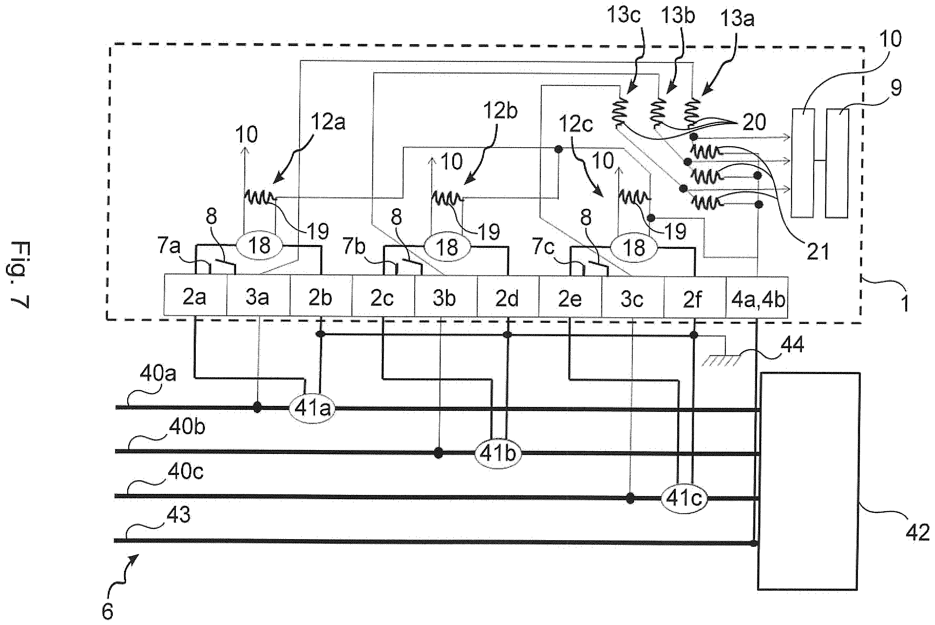

Lorsque le compteur 1 est connecté au réseau de distribution 6 via les transformateurs 41, le module d'adaptation 24 est monté sur le compteur 1, et le compteur 1 se trouve dans la deuxième configuration. Cette situation est visible sur la figure 7. Le compteur 1 présenté à la figure 7 est le même, au niveau matériel *(hardware)* que le compteur 1 présenté à la figure 6 (si ce n'est que le module d'adaptation 24 est ici monté sur le compteur 1).

Le premier conducteur de phase 40a comporte un premier transformateur 41a. Le deuxième conducteur de phase 40b comporte un deuxième transformateur 41b. Le troisième conducteur de phase 40c comporte un troisième transformateur 41c.

Chaque transformateur 41, en forme de tore, permet de ramener les courants très élevés (plusieurs centaines d'ampères) circulant sur les conducteurs de phase 40 à des courants plus faibles compatible avec les capteurs de courant 12 du compteur 1.

Le premier transformateur 41a est traversé sans y être relié par le premier conducteur de phase 40a. Le premier transformateur 41a comporte un secondaire ayant une première borne reliée au premier port de courant amont 2a et ayant une deuxième borne reliée au premier port de courant aval 2b.

Le premier conducteur de phase 40a associé au premier transformateur 41a est par ailleurs relié au premier port de tension 3a via le premier élément conducteur 31a du module d'adaptation 24 monté sur le compteur 1. Le premier conducteur de phase 40a est connecté à l'organe de connexion 36 du premier élément conducteur 31a.

Le premier coupe-circuit 7a est ouvert.

Le premier capteur de courant 12a mesure le courant qui circule entre le premier port amont 2a et le premier port aval 2b, et donc le courant qui circule dans le secondaire du premier transformateur 41a (qui est une image du courant circulant effectivement sur le premier conducteur de phase 40a).

Le premier capteur de tension 13a, connecté au premier port de tension 3a et donc au premier conducteur de phase 40a en amont du compteur 1, via le premier élément conducteur 31a du module d'adaptation 24 et via le contact mobile 8 du premier coupe-circuit 7a, mesure la tension sur le premier conducteur de phase 40a en amont du compteur 1.

Tout ceci s'applique aussi au deuxième conducteur de phase 40b (avec le deuxième transformateur 41b, le deuxième capteur de courant 12b et le deuxième capteur de tension 13b) et au troisième conducteur de phase 40c (avec le troisième transformateur 41c, le troisième capteur de courant 12c et le troisième capteur de tension 13c).

Les deuxièmes bornes des secondaires des transformateurs 41 sont reliées entre elles et sont connectées à une terre 44 de l'installation électrique 42 du client.

Le premier port de neutre 4a (équipotentiel au deuxième port de neutre 4b) du compteur 1 est connecté au conducteur de neutre 43 du réseau de distribution 6. Le deuxième port de neutre 4b est connecté à une masse de l'installation électrique 42 du client.

On note que les mesures de courant réalisées par le premier capteur de courant 12a sont complètement décorrélées des mesures de tension réalisées par le premier capteur de tension 13a. Ceci s'applique aussi aux mesures réalisées par le deuxième capteur de courant 12b et le deuxième capteur de tension 13b, et par le troisième capteur de courant 12c et le troisième capteur de tension 13c.

Comme le module d'adaptation 24 est monté sur le compteur 1, le détecteur détecte la présence du module d'adaptation 24. Le microcontrôleur 9 effectue donc un deuxième traitement utilisant des deuxièmes paramètres sur les mesures de courant et de tension. En particulier, le deuxième traitement prend en compte le fait que le compteur 1 est connecté via les transformateurs 41 au réseau de distribution 6, pour produire des mesures correspondant aux courants et aux tensions effectivement présents sur le réseau de distribution 6.

Ainsi, le premier traitement et le deuxième traitement différent notamment par la prise en compte du rapport de transformation des transformateurs 41.

On note que, lorsque la configuration du compteur 1 est réalisée en usine, il peut être avantageux de monter le module d'adaptation 24 sur le compteur 1 avant le bouterollage et la calibration usine du compteur 1. Le compteur 1 se trouve ainsi dans la deuxième configuration, muni du module d'adaptation 24, pour définir des paramètres de calibration éventuellement utilisés par le deuxième traitement.

Bien entendu, l'invention n'est pas limitée au mode de réalisation décrit mais englobe toute variante entrant dans le champ de l'invention telle que définie par les revendications.

Bien que le compteur présenté ici soit un compteur triphasé, l'invention s'applique bien sûr à un compteur monophasé ou à tout type de compteur polyphasé.

Bien que le compteur selon la première configuration et le compteur selon la deuxième configuration décrits ici soient des compteurs identiques au niveau *hardware* (à l'exception de la présence du module d'adaptation), il est possible de prévoir de remplacer les tores internes, sur site, pour les adapter à la deuxième configuration du compteur. Avantageusement, on prévoira de pouvoir remplacer les tores internes sans débouteroller le compteur. Les bras de cuivre des coupe-circuits et les tores internes associés sont alors par exemple amovibles et accessibles par simple ouverture du capot amovible (qui est lui-même possiblement scellé au compteur).

On a décrit ici l'utilisation de coupe-circuits. Par « coupe-circuit », on entend tout type d'organe de coupure, d'interrupteur, de commutateur, adaptés à ouvrir et à fermer un circuit électrique grâce au mouvement d'un contact mobile.

On a équipé ici le compteur d'un détecteur pour détecter automatiquement la présence du module d'adaptation, ce qui permet au microcontrôleur d'adapter automatiquement le traitement réalisé en fonction de la configuration du compteur. Il serait aussi possible d'équiper le compteur d'une interface permettant, depuis l'extérieur du compteur, de communiquer au microcontrôleur si le compteur se trouve dans la première configuration ou dans la deuxième configuration. Cette interface peut par exemple être une interface manuelle, accessible par un opérateur, ou bien une interface informatique, accessible par un serveur.

## Revendications

1. Compteur d'énergie électrique configurable selon une première configuration dans laquelle le compteur est adapté à être connecté directement à un conducteur de phase (40) d'un réseau de distribution (6), et selon une deuxième configuration dans laquelle le compteur est adapté à être connecté au conducteur de phase (40) via un transformateur (41) situé sur le conducteur de phase, le compteur comportant un port de courant amont (2a, 2c, 2e) et un port de courant aval (2b, 2d, 2f) destinés à être connectés au conducteur de phase, un port de tension (3), un coupe-circuit (7) fermé par défaut comprenant un contact mobile (8) ayant une extrémité fixe connectée au port de tension et une extrémité mobile connectée au port de courant amont lorsque le coupe-circuit est fermé, un dispositif d'accueil adapté à accueillir un module d'adaptation (24), et un orifice d'accès (25) au travers duquel s'étend un élément conducteur (31) du module d'adaptation lorsque celui-ci est monté sur le compteur, de sorte que, lorsque le module d'adaptation est monté sur le compteur, l'élément conducteur est en contact avec le contact mobile du coupe-circuit et ouvre le coupe-circuit tout en étant connecté avec le port de tension, le compteur se trouvant alors dans la deuxième configuration, et lorsque le module d'adaptation (24) n'est pas monté sur le compteur, le compteur se trouve dans la première configuration.

2. Compteur selon la revendication 1, comprenant une base fixe (23) dans lequel est pratiqué l'orifice d'accès (25).

3. Compteur selon la revendication 1, comprenant un module de traitement (9) connecté au capteur de courant et au capteur de tension, le module de traitement étant adapté à réaliser un premier traitement sur des mesures de courant et sur des mesures de tension lorsque le compteur se trouve dans la première configuration, et un deuxième traitement sur les mesures de courant et sur les mesures de tension lorsque le compteur se trouve dans la deuxième configuration.

4. Compteur selon la revendication 3, dans lequel le premier traitement et le deuxième traitement diffèrent par la prise en compte d'un rapport de transformation du transformateur (41).

5. Compteur selon la revendication 1, comprenant un détecteur adapté à détecter si le compteur se trouve dans la première configuration ou dans la deuxième configuration, et à transmettre le résultat de la détection au module de traitement (9).

6. Compteur selon la revendication 3, comprenant une interface permettant, depuis l'extérieur du compteur, de communiquer au module de traitement si le compteur se trouve dans la première configuration ou dans la deuxième configuration.

7. Module d'adaptation adapté à configurer un compteur selon l'une des revendications précédentes, le module d'adaptation (24) comprenant un dispositif de fixation (32) adapté à fixer le module d'adaptation sur le compteur et un élément conducteur (31) destiné à s'étendre dans l'orifice d'accès du compteur, l'élément conducteur comprenant à une première extrémité un organe de connexion (36) adapté à être connecté au conducteur de phase du réseau de distribution, et une deuxième extrémité élargie (37) adaptée à encliqueter l'élément conducteur (31) dans le compteur.

8. Système comprenant un compteur (1) selon l'une des revendications 1 à 6 et un module d'adaptation (24) selon la revendication 7.

9. Procédé de configuration d'un compteur selon l'une des revendications 1 à 6, comportant les étapes :
- de déterminer si le compteur est destiné à être connecté directement à un conducteur de phase (40) d'un réseau de distribution (6), ou bien si le compteur est destiné à être connecté au conducteur de phase via un transformateur (41) situé sur le conducteur de phase (40) ;
- si le compteur est destiné à être connecté via le transformateur (41), de monter un module d'adaptation selon la revendication 7 sur le compteur.

## Patentansprüche

1. Stromzähler, der gemäß einer ersten Konfiguration konfigurierbar ist, in der der Zähler dazu geeignet ist, direkt an einen Phasenleiter (40) eines Verteilungsnetzes (6) angeschlossen zu werden, sowie gemäß einer zweiten Konfiguration, in der der Zähler dazu geeignet ist, an den Phasenleiter (40) über einen Transformator (41) angeschlossen zu werden, der sich auf dem Phasenleiter befindet, wobei der Zähler einen stromaufwärtigen Stromanschluss (2a, 2c, 2e) und einen stromabwärtigen Stromanschluss (2b, 2d, 2f) umfasst, die dazu bestimmt sind, mit dem Phasenleiter verbunden zu werden, einen Spannungsanschluss (3), einen standardmäßig geschlossenen Unterbrecher (7), der einen beweglichen Kontakt (8) umfasst, der ein ortsfestes Ende hat, das mit dem Spannungsanschluss verbunden ist, und ein bewegliches Ende, das mit dem stromaufwärtigen Stromanschluss verbunden ist, wenn der Unterbrecher geschlossen ist, eine Aufnahmevorrichtung, die dazu geeignet ist, ein Adaptionsmodul (24) aufzunehmen, und eine Zugangsöffnung (25), durch die sich ein Leitungselement (31) des Adaptionsmoduls erstreckt, wenn dieses an dem Zähler montiert ist, sodass, wenn das Adaptionsmodul an dem Zähler montiert ist, das Leitungselement mit dem beweglichen Kontakt des Unterbrechers in Kontakt ist und den Unterbrecher öffnet, während es mit dem Spannungsanschluss verbunden ist, wobei sich der Zähler dann in der zweiten Konfiguration befindet, und wenn das Adaptionsmodul (24) nicht an dem Zähler montiert ist, sich der Zähler in der ersten Konfiguration befindet.

2. Zähler nach Anspruch 1, umfassend eine ortsfeste Basis (23), in der die Zugangsöffnung (25) ausgebildet ist.

3. Zähler nach Anspruch 1, umfassend ein Verarbeitungsmodul (9), das mit dem Stromsensor und dem Spannungssensor verbunden ist, wobei das Verarbeitungsmodul dazu geeignet ist, eine erste Verarbeitung an Strommessungen und an Spannungsmessungen durchzuführen, wenn sich der Zähler in der ersten Konfiguration befindet, und eine zweite Verarbeitung an den Strommessungen und an den Spannungsmessungen durchzuführen, wenn sich der Zähler in der zweiten Konfiguration befindet.

4. Zähler nach Anspruch 3, bei dem sich die erste Verarbeitung und die zweite Verarbeitung durch die Berücksichtigung eines Transformationsverhältnisses des Transformators (41) unterscheiden.

5. Zähler nach Anspruch 1, umfassend einen Detektor, der dazu geeignet ist, zu erfassen, ob sich der Zähler in der ersten Konfiguration oder in der zweiten Konfiguration befindet, und das Ergebnis der Erfassung an das Verarbeitungsmodul (9) zu übertragen.

6. Zähler nach Anspruch 3, umfassend eine Schnittstelle, die von außerhalb des Zählers ermöglicht, dem Verarbeitungsmodul mitzuteilen, ob sich der Zähler in der ersten Konfiguration oder in der zweiten Konfiguration befindet.

7. Adaptionsmodul, das dazu geeignet ist, einen Zähler nach einem der vorhergehenden Ansprüche zu konfigurieren, wobei das Adaptionsmodul (24) eine Befestigungsvorrichtung (32) umfasst, die dazu geeignet ist, das Adaptionsmodul an dem Zähler zu befestigen, sowie ein Leitungselement (31), das dazu bestimmt ist, sich in die Zugangsöffnung des Zählers zu erstrecken, wobei das Leitungselement an einem ersten Ende ein Anschlussorgan (36) umfasst, das dazu geeignet ist, an den Phasenleiter des Verteilungsnetzes angeschlossen zu werden, und ein vergrößertes zweites Ende (37), das dazu geeignet ist, das Leitungselement (31) in den Zähler einzurasten.

8. System, umfassend einen Zähler (1) nach einem der Ansprüche 1 bis 6 und ein Adaptionsmodul (24) nach Anspruch 7.

9. Verfahren zum Konfigurieren eines Zählers nach einem der Ansprüche 1 bis 6, umfassend die Schritte:
- Bestimmen, ob der Zähler dazu bestimmt ist, direkt an einen Phasenleiter (40) eines Verteilungsnetzes (6) angeschlossen zu werden, oder ob der Zähler dazu bestimmt ist, an den Phasenleiter über einen Transformator (41), der sich auf dem Phasenleiter (40) befindet, angeschlossen zu werden;
- wenn der Zähler dazu bestimmt ist, über den Transformator (41) angeschlossen zu werden, Montieren eines Adaptionsmoduls nach Anspruch 7 an dem Zähler.

## Claims

1. An electricity meter configurable to occupy a first configuration in which the meter is adapted to be connected to a phase conductor (40) of a distribution network (6) directly, and to occupy a second configuration in which the meter is adapted to be connected to the phase conductor (40) via a transformer (41) situated on the phase conductor, the meter having an upstream current port (2a, 2c, 2e) and a downstream current port (2b, 2d, 2f) for connecting to the phase conductor, a voltage port (3), a disconnector (7) that is closed by default having a movable contact (8) with a stationary end connected to the voltage port and a movable end connected to the upstream current port when the disconnector is closed, a docking device adapted to dock an adapter module (24), and an access orifice (25) through which a conductive element (31) of the adapter module extends when the adapter module is mounted on the meter, such that when the adapter module is mounted on the meter, the conductive element is in contact with the movable contact of the disconnector and opens the disconnector while being connected to the voltage port, the meter then occupying the second configuration, and when the adapter module (24) is not mounted on the meter, the meter occupies the first configuration.

2. A meter according to claim 1, including a fixed base (23) in which the access orifice (25) is formed.

3. A meter according to claim 1, including a processor module (9) connected to the current sensor and to the voltage sensor, the processor module being adapted to perform first processing on the current measurements and on the voltage measurements when the meter is in the first configuration, and second processing on the current measurements and the voltage measurements when the meter is in the second configuration.

4. A meter according to claim 3, wherein the first processing and the second processing differ by taking account of a transformation ratio of the transformer (41) .

5. A meter according to claim 1, including a detector adapted to detect whether the meter is in the first configuration or is in the second configuration, and for transmitting the results of the detection to the processor module (9).

6. A meter according to claim 3, including an interface making it possible from outside the meter to inform the processor module whether the meter is in the first configuration or in the second configuration.

7. An adapter module adapted to configure a meter according to any preceding claim, the adapter module (24) comprising a fastener device (32) adapted to fasten the adapter module on the meter and a conductive element (31) designed to extend through the access orifice of the meter, the conductive element having a connection member (36) at a first end adapted to be connected to the phase conductor of the distribution network, and having a second end (37) that is enlarged and adapted to snapfasten the conductive element (31) in the meter.

8. A system comprising a meter (1) according to any one of claims 1 to 6, and an adapter module (24) according to claim 7.

9. A method of configuring a meter according to any one of claims 1 to 6, the method comprising the steps of:
- determining whether the meter is to be connected to a phase conductor (40) of a distribution network (6) directly, or whether the meter is to be connected to the phase conductor via a transformer (41) situated on the phase conductor (40);
- if the meter is to be connected via the transformer (41), mounting an adapter module according to claim 7 on the meter.
